# EUROPEAN PATENT APPLICATION

(11) **EP 4 625 467 A2**
(43) Date of publication of application: **01.10.2025**
(21) Application number: 25165907.4
(22) Date of filing: 25.03.2025
(51) Int. Cl.: H01J 37/20, H01J 37/18

(54) **AIRLESS TRANSFER AND ELECTRICAL TESTING OF SOLID STATE BATTERIES IN SCANNING ELECTRON MICROSCOPES**

(30) Priority: 26.03.2024 US 202418617387
(71) Applicant: FEI Company, Hillsboro, OR 97124-5793 (US)
(72) Inventor: NOVÁK, Libor, 627 00 Brno (CZ); LÁSKO, Jan, 627 00 Brno (CZ); GLEMBEK, Jan, 627 00 Brno (CZ)
(74) Representative: Boult Wade Tennant LLP

(57) **Abstract**

Apparatus include a sample carrier including a base member and a sample support assembly coupled to the base member, wherein the sample support assembly includes a holder having opposing first and second holder portions configured to compress a sample within a holder receiving portion, wherein the base member is configured to engage a sample stage within a microscope chamber. Methods include securing a sample carrier in a microscope chamber and charging/discharging the sample at least in part through an electrical coupling in the chamber.

## Description

### FIELD

The field is sample testing in controlled environments.

### BACKGROUND

In many charged particle beam microscope and processing applications, samples require processing in an environment separate from a vacuum-controlled chamber of the charged particle beam microscope, along with clean transport between the environments. Unfortunately, existing solutions often fail to maintain cleanliness of the sample or other required sample conditions, or they require laborious or inefficient steps to process or test the samples. These problems are particularly notable for battery and battery-related samples. Thus, a need remains for improved techniques and apparatus that remedy these shortcomings.

### SUMMARY

According to an aspect of the disclosed technology, apparatus include a sample carrier including a base member and a sample support assembly coupled to the base member, wherein the sample support assembly includes a holder having opposing first and second holder portions configured to compress a sample within a holder receiving portion, wherein the base member is configured to engage a sample stage within a microscope chamber.

According to another aspect of the disclosed technology, apparatus include a sample carrier receiver including a support having a base member that couples to a stage within a microscope chamber and having a receiving portion coupled to the base member, wherein the receiving portion includes a slide mount that extends at an oblique angle relative to the base member to receive and secure a sample carrier in relation to a sample stage within the microscope chamber through slidable engagement with the slide mount; wherein the receiving portion includes an electrical engaging portion that couples to an electrical engaging portion of the sample carrier to provide an electrically conductive path from the sample carrier through the stage.

According to another aspect of the disclosed technology, methods include engaging an airless transfer capsule with an airless transfer capsule transfer port of a microscope vacuum chamber, wherein the airless transfer capsule stores a sample carrier; inserting the sample carrier from the airless transfer capsule into the microscope vacuum chamber by moving the sample carrier into a sample carrier receiver mounted to a sample stage situated in the vacuum chamber; and electrically coupling an electrical engaging portion on the sample carrier and an electrical engaging portion on the sample carrier receiver.

According to a further aspect of the disclosed technology methods include securing a sample carrier to a sample stage within a microscope chamber, wherein the sample carrier includes a slide member and sample support assembly coupled to the slide member, wherein the sample support assembly includes a holder having opposing first and second holder portions configured to compress a sample within a holder receiving portion, wherein the securing includes slidably engaging the slide member to a sample carrier receiver coupled to the sample stage and electrically coupling respective electrical engaging portions of the sample carrier and sample carrier receiver; and charging and/or discharging the sample at least in part through the electrical coupling

The foregoing and other objects, features, and advantages of the disclosed technology will become more apparent from the following detailed description, which proceeds with reference to the accompanying figures.

### BRIEF DESCRIPTION OF THE DRAWINGS

FIG. 1 is a schematic of an example charged particle beam microscope.
FIGS. 2A-2C are side view schematics of an example sample carrier and receiver system.
FIGS. 3A-3B are side view schematics of another example sample carrier and receiver system
FIG. 4 is a perspective view of a sample carrier engaged to a sample receiver.
FIG. 5 is a perspective view of another sample carrier engaged to a sample receiver having an angled configuration.
FIG. 6 is a flowchart of an example method of transferring a sample carrier from an airless transfer capsule into a vacuum chamber.

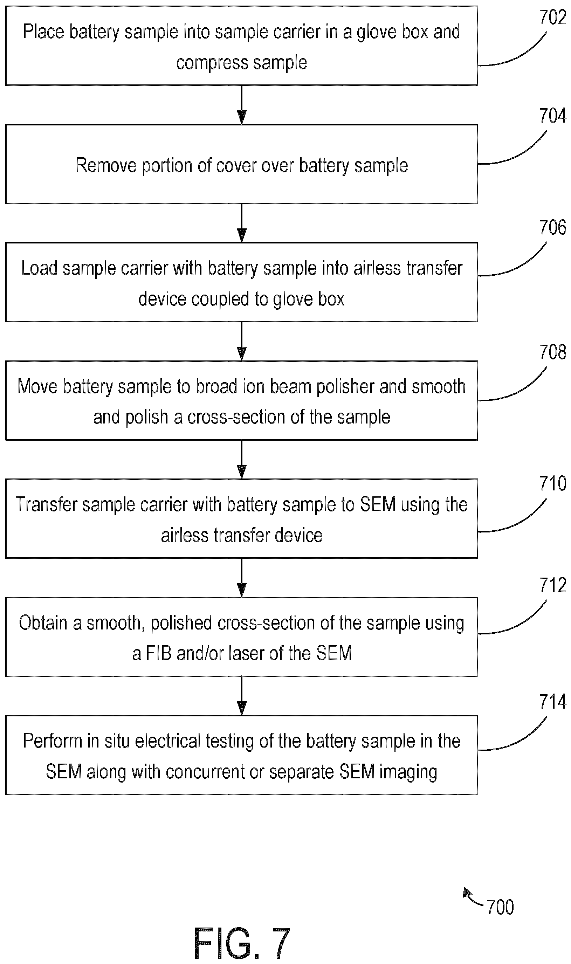

FIG. 7 is a flowchart of an example method of processing and experimenting upon a battery sample.

### DETAILED DESCRIPTION

Representative examples use a vacuum-controlled shuttle transport system to allow for electrical testing and compression of a solid-state battery inside scanning electron microscopes (SEMs). Herein, "vacuum-controlled" generally refers to systems having the ability to control a level of vacuum in an internal volume, including with respect to selected species (such as air, nitrogen, inert gases, etc.). A small compression element such as a piezo actuator is incorporated into part of the shuttle of the vacuum-controlled shuttle transport system. The compression element can then be used to compress a sample, e.g., of a solid-state battery or coin cell under electrical testing in the vacuum-controlled chamber of the SEM, including, in some examples, during simultaneous SEM imaging. Various examples can combine airless transfer of a solid-state battery sample using the vacuum-controlled shuttle transport system, electrical testing (e.g., charging and discharging cycles) in the SEM, control of the compressive pressure acting on the electrodes of the solid-state battery sample (e.g., in units of MPa), and/or simultaneous SEM imaging. Examples can be effective to provide SEM imaging of battery structural changes with respect to variations in compressive pressure and charging/discharging parameters.

Solid-state batteries (SSBs) are a promising emerging technology that can afford increased power density, reduced size, and reduced weight as compared to current batteries that rely upon a liquid electrolyte for ion transport. SSBs include a solid-state separator between anode and cathode that operates as the medium through which ions move. In addition, one or more of the anode or cathode can be formed of a solid, continuous layer of material such as lithium metal. During operation of the SSB, ion transport can result in the accumulation of additional solid material (e.g., lithium metal) on the anode. For example, the thickness of the anode can change by several tens of microns during charging. One of the key challenges of SSB production is producing a battery structure with sufficient containment to ensure good contact between layers (e.g., anode, separator, and cathode) while also allowing for expansion and contraction of the size of the anode layer during charging and discharging.

Systems and methods of the present disclosure enable preparation and measurement of layer morphology and composition of samples such as SSBs over a range of experimental conditions. These experimental conditions can include electrical state (i.e., charged, discharged, or transient between charge states), temperature, vacuum pressurization, and applied compressive pressure.

Examples taught herein can be used to provide direct insight into the changes of solid-state batteries during charging and discharging. For example, optimum working conditions for SSBs can be strongly dependent on the pressure between the electrodes, which can be controllable in selected examples using, e.g., a compression element. In some examples, the compression element can adjust the compression on the SSB in response to changes in internal pressure within the SSB as a result of anode expansion due to accumulation of material during operation of the SSB. The adjustment can apply a desired pressure based upon experimental design or can maintain a same pressure before and after anode expansion.

Examples taught herein can also enable safe preparation of samples (e.g., SSBs) outside of the charged particle microscope under continuous application of vacuum pressure and/or compressive pressure followed by insertion into the charged particle microscope for measurement or imaging. Solid-state batteries (SSBs) can include components that are highly reactive with ambient air and can present a danger of fire or explosion if exposed to air. For example, an anode of the SSB can be formed of a solid layer of lithium metal. Example sample supports taught herein can apply compressive pressure to the sample while the sample is cut or polished to expose the anode while outside the charged particle microscope. Such cutting or polishing can occur under vacuum or inert gas conditions. The sample stage can then be inserted into the charged particle microscope under airless conditions while still applying compressive pressure to the sample.

Examples can be small and compact so that precise placement can be allowed for the battery sample into a holder that may already be situated in an associated glove-box external to the microscope that is used to handle and process the battery sample.

In some conventional systems, a large compression stage is situated in the SEM chamber. In some arrangements, insertion into the large stage already present in the chamber requires restoring vacuum pressurization to atmospheric levels to place the sample in the chamber. This procedure causes significant delays while the chamber is vented and then pumped back down to vacuum conditions. Moreover, the sample is not being compressed during the insertion and positioning of the sample into the stage situated in the chamber. The loss of compression applied to the sample (i.e., in the time during where the sample is placed into the large compression stage) can adversely affect the experimental results. For example, the original electrical properties of the SSB can significantly change if compression between the electrodes and electrolyte (separator) was lost. Systems and method described herein overcome these issues by enabling insertion of the sample into the charged particle microscope under airless conditions while continuous compression is applied to the sample (i.e., the application of compression is not disrupted).

In disclosed examples, the battery samples can be transferred without contact with air, e.g., by placing the sample into the chamber of the SEM while the chamber is under vacuum. In many examples, testing and imaging steps can be further combined with sample heating and/or cooling in the chamber of the SEM. For example, some systems as taught herein can include a heating and/or cooling element (e.g., thermoelectric cooler or heater) that can adjust a temperature of the sample in a range from 30K to 450K.

Various examples can provide for maintained and/or adjustable compressive pressure applied to a sample during airless transport, e.g., from a glovebox or BIB polisher to an SEM vacuum chamber. Such applied pressure can be beneficial for SSB experiments, such as with pouch cells. The pouch of a pouch cell often cannot assure that a sufficient pressure is applied during battery cycling (even with complete pouch cells) such that a compressive force applied during charge cycling improves performance and may be required during experiments. Further, where part of the pouch is removed to allow for SEM imaging of sample cross-section and related experimentation, compression can be more important. Further, where no pouch is provided for an SSB in accordance with some experiments (e.g., with an open battery), compression can be required for successful analysis. Also, such compression can be provided during the transfer of a sample to prevent delamination during transfer and during possible broad ion beam polishing before delivery to a SEM or other analysis tool.

In some examples, a sample holder mounted in the vacuum chamber of the SEM that receives the shuttle from the vacuum-controlled shuttle transport system is pre-tilted at an oblique angle (e.g., 45 degrees). This arrangement can be particularly beneficial in multi-beam SEMs, such as two- or three-beam focused ion beam (FIB) systems that include separate electron, focused-ion-beam (such as plasma FIB), and/or laser columns. The angled arrangement can allow for transfer of the shuttle with the sample holder angled with an internal movement stage so that, e.g., the coin-cell or battery sample can be transferred in a flat position perpendicular to a z-axis of the electron beam column. The movement stage can then return to a flat position so that the sample is then angled relative to the z-axis of the electron beam column such that it aligns perpendicularly with the beam axes of the PFIB and/or laser columns. The shuttle can allow for airless transfer (e.g., under argon or vacuum) of a coin cell battery (e.g., CR2032) or similar size battery between a glove box and the microscope chamber (e.g., the vacuum chamber portion of FIB, SEM, or other charged particle microscope system), electrical contacting of a battery sample inside the vacuum chamber of the microscope (such as for charging/discharging during testing), PFIB prep of the battery sample cross-section in a spin mill mode (provided by the pre-tilt), and/or combined with cryogenic stage that can speed up and improve characteristics of the PFIB processing. In some examples, PFIB milling can be performed in a cross-sectional direction (e.g., through a battery sample) and/or in a flat direction (e.g., surface milling).

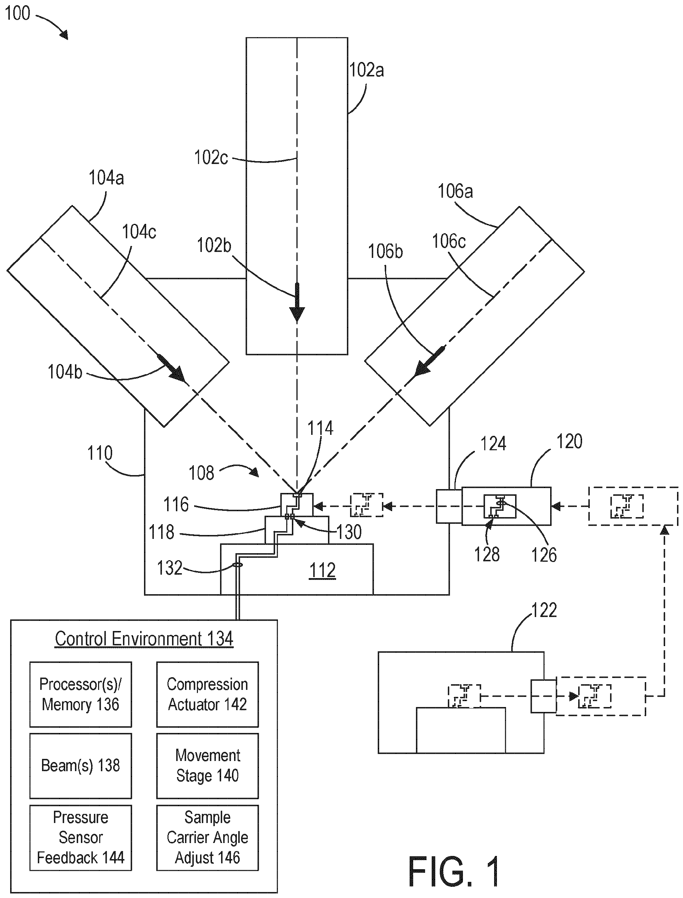

FIG. 1 is an example charged particle beam microscope 100 that includes three beam columns 102a, 104a, 106a that can produce electron, ion, and photon beams 102b, 104b, 106b, respectively, along respective beam axes 102c, 104c, 106c. The axes 102c, 104c, 106c are often arranged at predetermined angles with respect to each other, such as shown with axes 104c, 106c each being arranged at 45 degrees with respect to the axis 102c, to direct the respective beams 102b, 104b, 106b into a sample region 108 of a pressure controlled vacuum chamber 110. It will be appreciated that other angles are possible and need not be the same in three-beam examples. Other example angles can include 52 degrees, 30 degrees, 40 degrees, 60 degrees, 90 degrees, 110 degrees, etc. In some examples, the angle can be adjustable, e.g., with a hinge. A sample stage, such as a movement stage 112, is situated in the vacuum chamber 110 to control and manipulate a positioning of a sample 114 in the sample region 108, e.g., in relation to the beams 102b, 104b, 106b. The sample 114 is mounted on a movable sample carrier 116 (which also can be referred to as a shuttle) that is coupled to a sample carrier receiver 118 that is mounted to or part of the movement stage 112.

The sample carrier 116 with the mounted sample 114 can be transported into the vacuum chamber 110 with a vacuum-controlled shuttle transport system 120, e.g., in the form of an airless transfer capsule. In many workflows, the sample 114 mounted on the sample carrier 116 can be processed in another location, such as a glove-box 122, broad-ion-beam polishing apparatus, etc. After the transport system 120 is coupled to a vacuum chamber transport interface 124, the transport system 120 can be used to move the sample carrier 116 into the vacuum chamber 110 (e.g., via translation) to the sample region 108 to engage (e.g., via slidable contact) the sample carrier receiver 118. In many examples, the sample carrier 116 can include conductive paths 126 that couple components of the sample carrier 116 (such as one or more compressive actuators) and/or sample 114 (such as sample electrodes) to electrical engaging portions 128 that can align with and couple to electrical engaging portions 130 on the sample carrier receiver 118. The electrical engaging portions 130 can be coupled to one or more electrical sources through conductive paths 132, e.g., internal and/or external to the vacuum chamber 110. The conductive paths 126, 132 can allow the sample 114 to be transported into the vacuum chamber 110 and electrically tested therein while maintaining the vacuum-controlled environment surrounding the sample 114 throughout transport and testing.

In some examples, the sample carrier receiver 118 includes an angled extension that receives the sample carrier 116. During transport of the sample carrier 116 into the vacuum chamber 110, the movement stage 112 can cause a rotation of the sample carrier receiver 118 to a rotated position such that the angled extension can receive the sample carrier 116 from the transport system 120, e.g., in a predetermined aligned position that allows slidable engagement. The rotated position can provide the sample 114 in an imaging and/or processing position in relation to the electron beam axis 102c (e.g., perpendicular). After the sample carrier 116 is coupled to the sample carrier receiver 118, the movement stage 112 can cause a rotation of the sample carrier 116 (and sample 114) to an alternative position, such as a flat or default position of the movement stage 112. Where the axes 104c, 106c are at a common angle with the axis 102c (e.g., 45 degrees), the movement stage 112 can produce a rotation about the axis 102c to provide the sample 114 in a processing position (e.g., perpendicular) in relation to either beam 104b, 106b.

A control environment 134 can be coupled to or be part of the microscope 100 that includes a processor and memory 136 configured to control various components of the microscope 100, such as beam control 138, sample positioning with the movement stage 140, compression actuation 142, and sample powering (such as charging/discharging). In some examples, the compression actuation 142 can be controlled to provide a constant compressive pressure to the sample 114, such as during charging/discharging of the sample 114 in which the sample 114 is a battery or coin cell. In further samples, the applied compressive pressure can be controllably varied, e.g., in relation to charging/discharging voltage, current, or other experimental parameters, based on pressure sensor feedback 144 from a pressure sensor that is part of the sample carrier 116 and coupled to the sample 114 to detect applied compressive force. In some examples in which the sample carrier receiver 118 includes an angled extension, the angle of the extension can be controllably adjusted 146 through the control environment, e.g., with an actuator coupled to a hinge allowing angle adjustment of the extension. Such a hinge can correspond to a mechanically adjustable hinge in some examples as well.

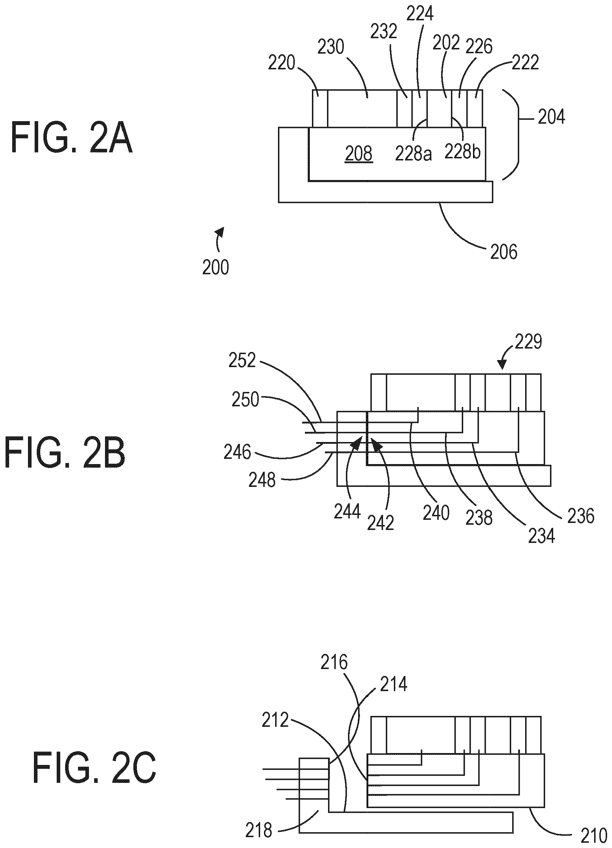

FIGS. 2A-2C illustrate an example sample carrier and receiver system 200 that can be used to test a sample 202, such as a coin cell or solid-state battery (SSB). The system 200 can include a sample carrier 204 and associated sample carrier receiver 206 that can be used in various examples herein. The sample carrier 204 can be used with a vacuum-controlled transport system that transports the sample carrier 204 in a vacuum-controlled environment and between vacuum-controlled environments. The sample carrier receiver 206 can be positioned in various environments, such as vacuum chambers of charged particle beam apparatus, glove-boxes, and broad ion beam polishers, to receive the sample carrier 204 from the vacuum-controlled transport system.

The sample carrier 204 can include a base member 208 that includes a surface 210 which can slidably engage an associated receiving surface 212 of the sample carrier receiver 206. The sample carrier 204 can slide to a secured position, e.g., by having a surface 214 that contacts a surface 216 of a stop 218. The stop 218 can have various forms, such as one or more abutment, detent, latch, catch, pawl, pin mechanisms, etc., that prevent undesirable movement of the sample carrier 204 during imaging and/or processing.

The sample carrier 204 can further include first and second holder portions 220, 222, and first and second electrical contacts 224, 226 that can face and contact respective electrode surfaces 228a, 228b of the sample 202 disposed in a holder receiving portion 229 of the sample carrier 204. A compressive actuator 230 can be coupled to first holder portion 220 to compress the sample 202, e.g., by forming a vise between the first and second holder portions 220, 222 as shown. For example, the first and second holder portions can be affixed to the base member 208 so that an expansion/contraction is provided between the first holder portion 220 and the electrical contact 224. The movement of the electrical contact 224 towards the sample 202 while movement is constrained by the first and second holder portions 220, 222 causes a compression of the sample 202. The compressive actuator 230 can also be coupled to the second holder portion 222 in some examples. In some examples, a pressure sensor 232 can be positioned in relation to the compressive actuator 230, e.g., between the compressive actuator 230 and the electrical contact 224, to detect a compressive pressure that is applied to the electrical contact 224 and thereby to the sample 202. Various compressive actuators may be used, particularly where a sufficiently small form factor can be provided, such as piezoelectric actuators, linear motors, etc. In some examples, the compressive actuator 230 provides an amount of compressive pressure in a range of 1 to 10 MPa. In some examples, the compressive actuator 230 can apply a force of about 1 kN. In some examples, the compressive actuator 230 can have a travel range of at least 15 µm to compensate for material build-up on the anode of the SSB during charging.

FIGS. 2B-2C further show electrically conductive paths 234, 236, 238, 240 that extend from the first and second electrical contacts 224, 226, the pressure sensor 232, and the compressive actuator 230, respectively, to an electrical engaging portion 242. In some examples, the electrical engaging portion 242 can be arranged at the surface 214 so that with the sample carrier 204 slidably engaged with the sample carrier receiver 206 (see interim position in FIG. 2C), one or more contact surfaces of the electrical engaging portion 242 can be conductively coupled to one or more mating or corresponding contact surfaces of an electrical engaging portion 244 arranged at the surface 216 of the stop 218. The electrical engaging portion 244 can be coupled to electrically conductive paths 246, 248, 250, 252 that electrically connect to respective conductive paths 234, 236, 238, 240. The paths 234, 236, 238, 240, 246, 248, 250, 252 can be used to transmit power and/or electrical signals to/from the various components of the sample carrier 204. In representative examples, the sample 202 can be a battery sample (e.g., SSB, coin cell, etc.) that is charged and discharged with the compressive actuator 230 applying a compressive force on the sample 202 in relation to the charging and discharging. In many examples, the compressive pressure applied to the sample 202 is maintained constant during charging/discharging (such as during an experiment win a microscopy chamber), transport, and/or processing. In further examples, the compressive pressure applied to the sample can be controllably varied, e.g., in relation to charging/discharging cycles. The pressure sensor 232 can be used to provide feedback for monitoring and/or controlling the compressive pressure applied to the sample 202. In some examples, the pressure is maintained at a constant pressure during expansion/contraction. In further examples, the pressure can be varied in relation to expansion/contraction.

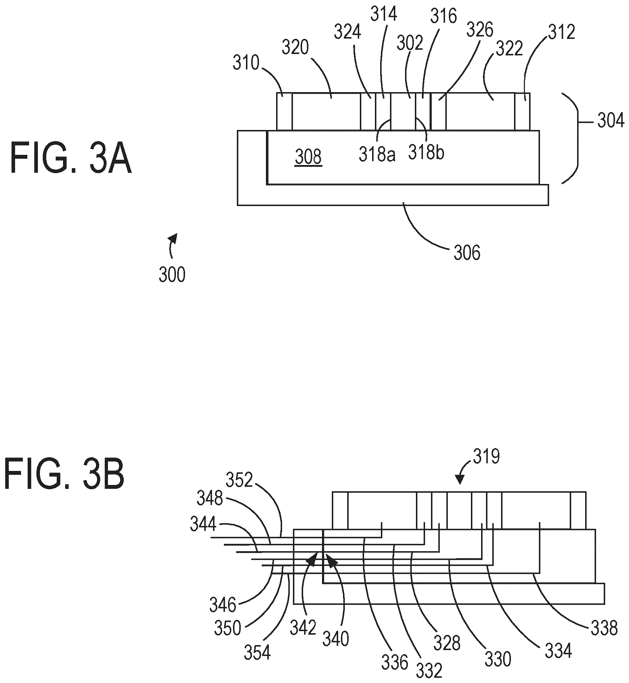

FIGS. 3A-3B show another example of a sample carrier and receiver system 300 that can be used to test a sample 302 (such as a battery sample). The system 300 can include many similar components as the system 200 though different components may be used as well. For example, the system 300 can include a sample carrier 304 and associated sample carrier receiver 306. The sample carrier 304 can include a base member 308. The sample carrier 304 can slide to a secured position, coupled to the sample carrier receiver 306. The sample carrier 304 can include first and second holder portions 310, 312, and first and second electrical contacts 314, 316 that can face and contact respective electrode surfaces 318a, 318b of the sample 302 disposed in a holder receiving portion 319 of the sample carrier 304.

First and second compressive actuators 320, 322 can be coupled to first and second holder portions 310, 312, respectively, e.g., by forming a vise between the first and second holder portions 310, 312. For example, the first and second holder portions 310, 312 can be affixed to the base member 308 so that an expansion/contraction is provided between the first holder portion 310 and the electrical contact 314 and an opposing expansion/contraction is provided between the second holder portion 312 and the electrical contact 316. The movement of the electrical contacts 314, 316 towards the sample 202 while movement is constrained by the first and second holder portions 310, 312 causes a compression of the sample 302. In some examples, a pressure sensor 324 and/or pressure sensor 326 can be positioned in relation to the compressive actuators 320, 322 to detect a compressive pressure that is applied to the electrical contacts 314, 316 and thereby the sample 302.

FIG. 3B shows electrically conductive paths 328, 330, 332, 334, 336, 338 that extend from the first and second electrical contacts 314, 316, the pressure sensors 324, 326, and the compressive actuators 320, 322, respectively, to an electrical engaging portion 340. The electrical engaging portion 340 can be conductively coupled to an opposing electrical engaging portion 342. The electrical engaging portion 342 can be coupled to electrically conductive paths 344, 346, 348, 350, 352, 354 that electrically connect to respective conductive paths 328, 330, 332, 334, 336, 338. The paths 328, 330, 332, 334, 336, 338, 344, 346, 348, 350, 352, 354 can be used to transmit power and/or signal to/from the various components of the sampler carrier 304.

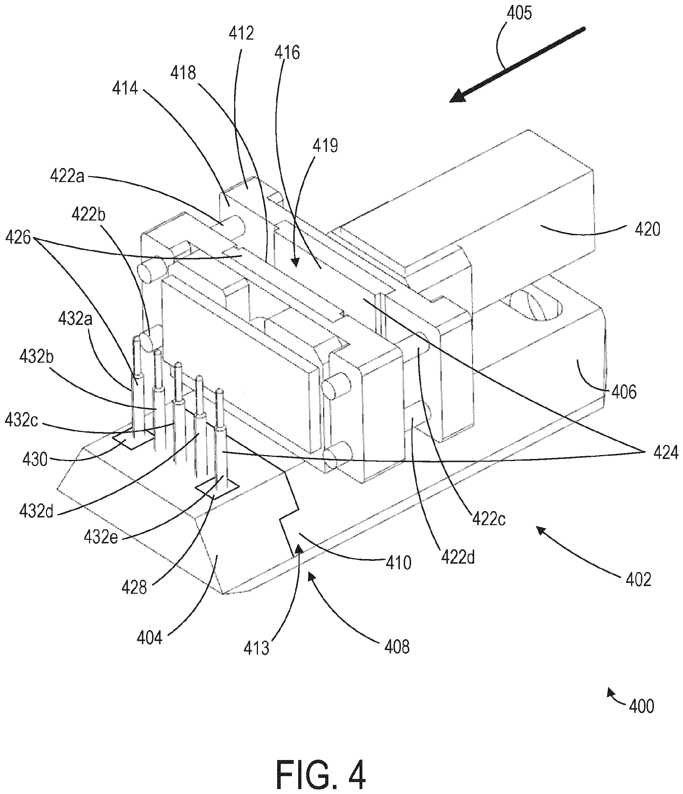

FIG. 4 is another example of a sample carrier and receiver system 400. The system 400 includes a sample carrier 402 and a sample carrier receiver 404. The sample carrier 402 can include a base member 406 that can slidably engage the sample carrier receiver 404. The sample carrier 402 can slide in a direction 405 to a secured position with a stop 408, which can include a lip 410 that fits within a corresponding slot 413 of the sample carrier receiver 404. The sample carrier 402 includes first and second holder portions 412, 414, and first and second electrical contacts 416, 418 that can face and contact electrode surfaces of a sample (not shown) that can be positioned between the electrical contacts 416, 418 in a holder receiving portion 419.

A compressive actuator 420 can be coupled to first holder portion 412 to compress the sample by translating the first electrical contact 416 towards the second electrical contact 418. The second holder portion 414 can be fixedly coupled to the base member 406. The first and second holder portions 412, 414 can be coupled to translate to and from each other with a linear slide bearing, e.g., with an arrangement of one or more shafts 422a-422d that can journal with respect to corresponding slotted portions of the first holder portion 412 or second holder portion 414. The compressive actuator 420 can be coupled to the base member 406 to provide secure translation of the first electrical contact 416.

With the sample carrier 402 engaged with the sample carrier receiver 404, the first and second electrical contacts 416, 418 can be coupled through conductive paths through the sample carrier 402, such as through the base member 406, to the sample carrier receiver 404. The first and second electrical contacts 416, 418 can be conductively coupled 424, 426 through the stop 408 (path hidden) or another part of the sample carrier 402 to electrodes 428, 430 on the sample carrier receiver 404. For example, one or more pins 432a-432e can extend or be made to extend at the engaged position to the sample carrier receiver 404, such as pins 432a, 432e to the electrodes 428, 430.

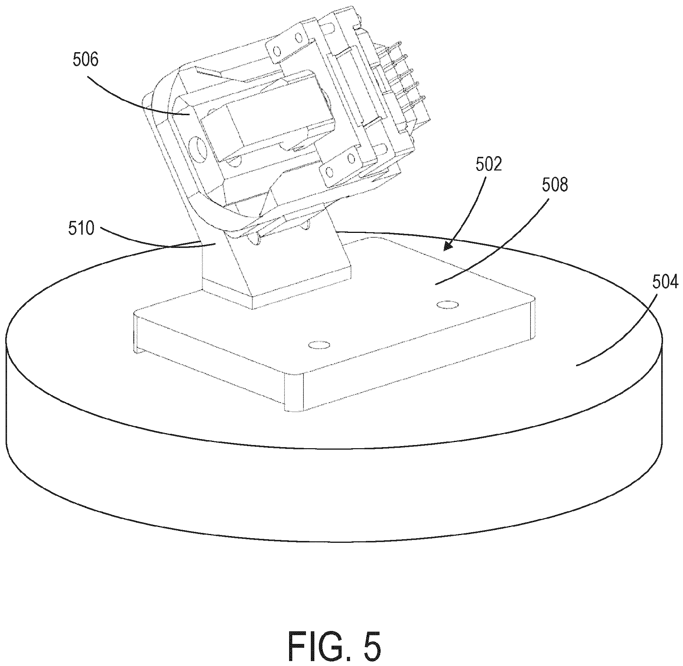

FIG. 5 is an example of a sample carrier and receiver system 500 that includes a sample carrier receiver 502 that is coupled to a sample stage, such as a movement stage 504, to receive a sample carrier 506. The sample carrier receiver 502 can include a base member 508 that can be coupled to the movement stage 504 and an angled extension member 510 that extends to provide a platform to receive the sample carrier 506 at a predetermined angle relative to the base member 508. In some examples, the angle can be adjustable.

The base member 508 can be heated and/or cooled with a related temperature control system coupled to the base member 508, e.g., below the base member 508 or as part of the base member 508. Thus, in many of such examples, the contacting of heating/cooling can be independent of the sample carrier 506 and electrical contact pins associated with the sample carrier. In further examples, a resistive heater, a Peltier cooling chip, etc., can be part of the sample carrier 506 such that it shares one or more pins or electrical contacts of the sample carrier 506.

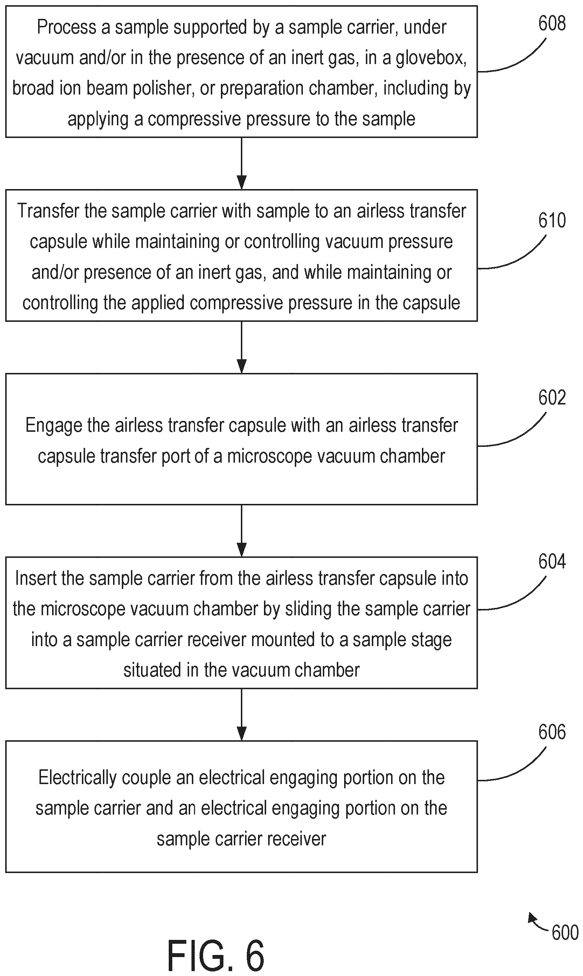

FIG. 6 is an example of a method 600 of transporting a transfer capsule, such as any of the sample carriers described herein. Example methods can include various steps performed alone as well as in combination with other steps. At 602, an airless transfer capsule engages an airless transfer capsule transfer port of a microscope vacuum chamber and a sample carrier is housed in the airless transfer capsule in a vacuum-controlled environment. In other words, "airless" generally can refer to the vacuum-controlled environment, which can also be controlled under other conditions (such as Nitrogen, Argon, etc.). At 604, the sample carrier from the airless transfer capsule is inserted into the microscope vacuum chamber by moving the sample carrier into a sample carrier receiver mounted to a sample stage situated in the vacuum chamber, e.g., by slidably engaging the sample carrier receiver. At 606, an electrical engaging portion on the sample carrier is electrically coupled and an electrical engaging portion on the sample carrier receiver. In some examples, various steps can be performed instead or additionally. For example, before or after the electrical coupling at 606 (e.g., pre- or post-experimentation within the microscope vacuum chamber), at 608, the sample can be processed under vacuum and/or in the presence of an inert gas. Processing can be mechanical, chemical, or involve optical-based operations with laser or ion beams. For example, processing can occur in a glovebox, broad ion beam polisher, or preparation/processing chamber. In many examples, a compressive pressure can be applied to the sample while processing occurs or as part of the processing workflow. At 610, the sample mounted on the sample carrier can be transferred from the processing chamber into the airless transfer capsule with vacuum pressure and/or the presence of an inert gas.

In a glovebox such as the one discussed at 608, the sample (such as a battery) can be mounted and compressed in the sample carrier. This can provide a maintained contact between electrodes and electrolyte of the sample (particularly for SSBs) which can avoid a negative effect on the performance of the tested sample. For example, a preload compression (resulting in approximately 1 MPa in the battery, though other values are possible, such as between 0.1 MPa and 5 MPa) can be applied during the mounting. In some examples, this pressure can be measured by a pressure sensor that is part of the sample carrier. A read-out from the pressure sensor can be connected to a controller, e.g., through a vacuum feedthrough of the glovebox or directly to a controller suitable for operation in an airless (e.g., argon) environment in the glovebox.

Compression applied to the sample on the sample carrier in the glovebox can be adjusted during the mounting and can be done in various ways. By way of example, one or a combination of the following ways may be used, including adding a spacer between the sample and a holding member. For reference with respect to system 200 (though these may be applied to any other disclosed examples as well), such a spacer may be added between the sample 202 and the first and/or second holder portions 220, 222, or between other components along the arrangement of components of the sample carrier 204. In some examples, a thickness of an element of the arrangement of components of the sample carrier 204 can be adjusted, e.g., with an adjustable screw in one or both of the first and second holder portions 220, 222, thereby causing compression of the sample 202. In further examples, one or more elastic members, such as springs, spring washers, elastic materials, rubber, etc., can be added to the arrangement of components of the sample carrier 204. In still further examples, a positioning of one or more elements of the arrangement of components of the sample carrier can be adjusted with respect to the base 208. For example, a positioning of the first and/or second holder portions 220, 222 can be adjusted to compress the distance between the sample 202, such as in a typical bench vise arrangement.

In many examples, compression adjusted in this way (such as within the glovebox) can be maintained using the compression actuator during the transfer, e.g., with a power source of the airless transfer capsule coupled to an electricity-based compressive actuator (such as a piezoelectric transducer) of the sample carrier, or more commonly with mechanical components, such as aforementioned spacers, vises, etc. Mechanically applied compression often can be in a passive form, such that the battery sample can be held together during the transport and additional or different compressive force applied by an electrical compressive actuator (such as a piezoelectric transducer) can be applied after the sample carrier is engaged with the SEM stage. In many examples it can be advantageous to transfer the SSB in charged state, because of an increased thickness in a charged state that will itself maintain a portion of the compression during transport. Subsequent discharging in an SEM can result in a corresponding contraction of the SSB sample that then can be taken up through the electrically operated compressive transducer in the SEM.

In a selected method example 700, at 702, a battery sample can be placed into a holder of a sample carrier, and compressed slightly (e.g., to approximately 1 MPa. In examples where the battery is not sealed in a pouch or coin cell, such placement is typically performed in a glove box. At 704, where the battery is encapsulated such as with a coin cell or pouch cell, part of the cover including part of the battery is removed to obtain a cross section that can be imaged in an SEM. Typically, such a step is performed in a glove box under argon. At 706, an airless transfer device connected to the glove box and a sample carrier that is loaded with the battery sample is loaded into the airless transfer device. At 708, the battery sample in the airless transfer device is moved to a broad ion beam polisher to smooth and polish a cross-section of the sample. For example, the airless transfer device can connect a chamber input to the broad ion beam polisher and the sample carrier can be transferred to the chamber under controlled vacuum/airless conditions. At 710, the sample carrier holding the battery sample can be transferred to an SEM (e.g., FIB-SEM, TriBeam, etc.) using the airless transfer device as it is transferred under airless conditions (e.g., under argon). At 712, a FIB and/or laser is used to obtain a smooth polished cross-section of the sample. At 714, in situ electrical testing on the battery sample can be performed in the SEM along with SEM imaging and optionally FIB imaging, which can be done concurrently or separately.

In some examples, 708 can be skipped and the sample carrier can be moved from glove box directly to the SEM (or FIB/laser system, etc.). In further examples, 712 can be skipped altogether. In selected examples, 708 and 712 can be skipped where the battery surface is already in acceptable state in glove box, e.g., where it has been suitably cross-sectioned and polished from a previous experiment. In some examples, 708, 710, 712, or a combination, can follow after 714 where more or improved polishing is needed at a later time during SEM analysis, e.g., before/after electrical testing in the SEM. In many examples of the method 700, the battery sample can remain in the same sample carrier throughout the process. In further examples, a different sample carrier may be used for selected steps, e.g., where a different holder may be required for BIB polishing. In such examples, the sample can be mounted to a dedicated BIB sample carrier in the glove box before and after BIB polishing at 708.

### General Considerations

As used in this application and in the claims, the singular forms "a," "an," and "the" include the plural forms unless the context clearly dictates otherwise. Additionally, the term "includes" means "comprises." Further, the term "coupled" does not exclude the presence of intermediate elements between the coupled items.

The systems, apparatus, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatus are not limited to any specific aspect or feature or combinations thereof, nor do the disclosed systems, methods, and apparatus require that any one or more specific advantages be present or problems be solved. Any theories of operation are to facilitate explanation, but the disclosed systems, methods, and apparatus are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one of ordinary skill in the art.

In some examples, values, procedures, or apparatuses are referred to as "lowest", "best", "minimum," or the like. It will be appreciated that such descriptions are intended to indicate that a selection among many used functional alternatives can be made, and such selections need not be better, smaller, or otherwise preferable to other selections.

Having described and illustrated the principles of the disclosed technology with reference to the illustrated embodiments, it will be recognized that the illustrated embodiments can be modified in arrangement and detail without departing from such principles. For instance, elements of the illustrated embodiments shown in software may be implemented in hardware and vice-versa. Also, the technologies from any example can be combined with the technologies described in any one or more of the other examples. It will be appreciated that procedures and functions such as those described with reference to the illustrated examples can be implemented in a single hardware or software module, or separate modules can be provided. The particular arrangements above are provided for convenient illustration, and other arrangements can be used.

### Additional Examples of the Disclosed Technology

Example 1. An apparatus, comprising a sample carrier including a base member and a sample support assembly coupled to the base member, wherein the sample support assembly includes a holder having opposing first and second holder portions configured to compress a sample within a holder receiving portion, wherein the base member is configured to engage a sample stage within a microscope chamber.
Example 2. The apparatus of example 1, wherein the base member includes a slide member configured to slidably engage the sample stage, wherein the slide member includes a stop that causes the sample carrier to stop at a slidably engaged position within the microscope chamber.
Example 3. The apparatus of any one of examples 1-2, wherein each of the first and second holder portions includes a first holder electrical contact and second holder electrical contact, respectively, that faces the sample to engage a respective sample electrode.
Example 4. The apparatus of any one of examples 1-3, wherein the first holder portion includes a compressive actuator that applies a compressive force to the sample.
Example 5. The apparatus of example 4, wherein the compressive actuator is a piezo-electric actuator.
Example 6. The apparatus of any one of examples 1-5, wherein the first and second holder portions comprise a vise.
Example 7. The apparatus of any one of examples 1-6, wherein the sample carrier includes an electrical engaging portion that is configured to become electrically coupled to the sample stage with the base member engaged with the sample stage within the microscope chamber.
Example 8. The apparatus of example 7, wherein the electrical coupling to the sample stage is through a slidable contact between contact surfaces of the electrical engaging portion and corresponding mating contact surfaces of the sample stage.
Example 9. The apparatus of example 7, wherein the electrical engaging portion includes engaging contact pins or receiving holes configured to provide the electrical coupling to the sample stage.
Example 10. The apparatus of any one of examples 7-9, wherein the sample carrier includes at least one conductive path electrically coupling at least a portion of the first holder portion to the electrical engaging portion.
Example 11. The apparatus of any one of examples 7-9, wherein the sample carrier includes:
   a first conductive path of the first holder portion, the first conductive path electrically coupling the first holder electrical contact to the electrical engaging portion;
   a second conductive path of the first holder portion, the second conductive path electrically coupling the compressive actuator to the electrical engaging portion; and
   a first conductive path of the second holder portion, the first conductive path electrically coupling the second holder electrical contact to the electrical engaging portion.
Example 12. The apparatus of any one of examples 10-11, wherein at least one of the conductive paths is coupled from the sample support assembly to the electrical engaging portion through the base member.
Example 13. The apparatus of any one of examples 10-12, wherein the electrical engaging portion is situated at the stop to electrically couple at least one of the conductive paths to the sample stage through the stop when the sample carrier is at the engaged position.
Example 14. The apparatus of any one of examples 1-13, wherein the second holder portion is fixed in relation to the base member.
Example 15. The apparatus of any one of examples 1-14, wherein the first and second holder portions are configured to hold a coin cell or solid-state battery for testing within the microscope chamber.
Example 16. The apparatus of example 15, wherein the microscope chamber is a SEM chamber, a FIB chamber, a FIB-SEM chamber, a laser and SEM chamber, or a three-beam SEM/PFIB/laser microscope chamber.
Example 17. An apparatus, comprising:
   a sample carrier receiver including a support having a base member that couples to a stage within a microscope chamber and having a receiving portion coupled to the base member, wherein the receiving portion includes a slide mount that extends at an oblique angle relative to the base member to receive and secure a sample carrier in relation to a sample stage within the microscope chamber through slidable engagement with the slide mount; wherein the receiving portion includes an electrical engaging portion that couples to an electrical engaging portion of the sample carrier to provide an electrically conductive path from the sample carrier through the stage.
Example 18. The apparatus of example 17, further comprising any of the apparatus of examples 1-16.
Example 19. A method, comprising:
   engaging an airless transfer capsule with an airless transfer capsule transfer port of a microscope vacuum chamber, wherein the airless transfer capsule stores a sample carrier;
   inserting the sample carrier from the airless transfer capsule into the microscope vacuum chamber by moving the sample carrier into a sample carrier receiver mounted to a sample stage situated in the vacuum chamber; and
   electrically coupling an electrical engaging portion on the sample carrier and an electrical engaging portion on the sample carrier receiver.
Example 20. The method of example 19, further comprising, before engaging the airless transfer capsule with the airless transfer capsule transfer port of the microscope vacuum chamber:
   arranging a battery sample on the sample carrier in a glove box and compressing the battery sample with the sample mounted to the sample carrier;
   mechanically processing the sample in the glove box to remove a portion of a cover of the sample;
   transferring the mechanically processed sample to the airless transfer capsule and then to a broad ion beam (BIB) polisher;
   polishing the sample supported by the sample carrier in the broad ion beam (BIB) polisher with a broad ion beam; and
   transferring the BIB-processed and mechanically processed sample to the airless transfer capsule.
Example 21. The method of any of examples 19-20, wherein during the inserting of the sample carrier from the airless transfer capsule into the microscope vacuum chamber, and/or during a movement and/or storage of the airless transfer capsule apart from the chamber, applying with a compressive actuator a compressive force to a sample held by the sample carrier.
Example 22. A method, comprising securing a sample carrier to a sample stage within a microscope chamber, wherein the sample carrier includes a slide member and sample support assembly coupled to the slide member, wherein the sample support assembly includes a holder having opposing first and second holder portions configured to compress a sample within a holder receiving portion, wherein the securing includes slidably engaging the slide member to a sample carrier receiver coupled to the sample stage and electrically coupling respective electrical engaging portions of the sample carrier and sample carrier receiver; and a charging and/or discharging the sample at least in part through the electrical coupling.
Example 23. The method of example 22, further comprising varying a compressive force applied to the sample during the charging and/or discharging at least in part through the electrical coupling.

In view of the many possible embodiments to which the principles of the disclosed technology may be applied, it should be recognized that the illustrated embodiments are only representative examples and should not be taken as limiting the scope of the disclosure. Alternatives specifically addressed in these sections are merely exemplary and do not constitute all possible alternatives to the embodiments described herein. For instance, various components of systems described herein may be combined in function and use. We therefore claim all that comes within the scope of the appended claims.

## Claims

1. An apparatus, comprising:
a sample carrier including a base member and a sample support assembly coupled to the base member, wherein the sample support assembly includes a holder having opposing first and
second holder portions configured to compress a sample within a holder receiving portion,
wherein the base member is configured to engage a sample stage within a microscope chamber.

2. The apparatus of claim 1, wherein the base member includes a slide member configured to slidably engage the sample stage, wherein the slide member includes a stop that causes the sample carrier to stop at a slidably engaged position within the microscope chamber.

3. The apparatus of any one of claims 1 or 2, wherein each of the first and second holder portions includes a first holder electrical contact and second holder electrical contact, respectively, that faces the sample to engage a respective sample electrode.

4. The apparatus of claim 3, wherein the first holder portion includes a compressive actuator, preferably a piezoelectric actuator, that applies a compressive force to the sample.

5. The apparatus of claim 4, wherein the sample carrier includes an electrical engaging portion that is configured to become electrically coupled to the sample stage with the base member engaged with the sample stage within the microscope chamber.

6. The apparatus of claim 5, wherein the electrical coupling to the sample stage is through a slidable contact between contact surfaces of the electrical engaging portion and corresponding mating contact surfaces of the sample stage.

7. The apparatus of claim 5, wherein the electrical engaging portion includes engaging contact pins or receiving holes configured to provide the electrical coupling to the sample stage.

8. The apparatus of claim 5, wherein the sample carrier includes at least one conductive path electrically coupling at least a portion of the first holder portion to the electrical engaging portion.

9. The apparatus of claim 5, wherein the sample carrier includes:
a first conductive path of the first holder portion, the first conductive path electrically coupling the first holder electrical contact to the electrical engaging portion;
a second conductive path of the first holder portion, the second conductive path electrically coupling the compressive actuator to the electrical engaging portion; and
a first conductive path of the second holder portion, the first conductive path electrically coupling the second holder electrical contact to the electrical engaging portion.

10. The apparatus of claim 8, wherein at least one of the conductive paths is coupled from the sample support assembly to the electrical engaging portion through the base member.

11. The apparatus of claim 8, wherein the base member includes a slide member configured to slidably engage the sample stage, wherein the slide member includes a stop that causes the sample carrier to stop at a slidably engaged position within the microscope chamber; wherein the electrical engaging portion is situated at the stop to electrically couple at least one of the conductive paths to the sample stage through the stop when the sample carrier is at the engaged position.

12. The apparatus of any one of claims 1-11, wherein the second holder portion is fixed in relation to the base member.

13. A method, comprising:
engaging an airless transfer capsule with an airless transfer capsule transfer port of a microscope vacuum chamber, wherein the airless transfer capsule stores a sample carrier;
inserting the sample carrier from the airless transfer capsule into the microscope vacuum chamber by moving the sample carrier into a sample carrier receiver mounted to a sample stage situated in the vacuum chamber; and
electrically coupling an electrical engaging portion on the sample carrier and an electrical engaging portion on the sample carrier receiver.

14. The method of claim 13, further comprising, before engaging the airless transfer capsule with the airless transfer capsule transfer port of the microscope vacuum chamber:
arranging a battery sample on the sample carrier in a glove box and compressing the battery sample with the sample mounted to the sample carrier;
mechanically processing the sample in the glove box to remove a portion of a cover of the sample;
transferring the mechanically processed sample to the airless transfer capsule and then to a broad ion beam (BIB) polisher;
polishing the sample supported by the sample carrier in the broad ion beam (BIB) polisher with a broad ion beam; and
transferring the BIB-processed and mechanically processed sample to the airless transfer capsule.

15. The method of any one of claims 13-14, wherein during the inserting of the sample carrier from the airless transfer capsule into the microscope vacuum chamber, and/or during a movement and/or storage of the airless transfer capsule apart from the chamber, applying with a compressive actuator a compressive force to a sample held by the sample carrier.
